# EUROPÄISCHE PATENTSCHRIFT

(11) **EP 0 447 628 B1**
(45) Veröffentlichungstag und Bekanntmachung des Hinweises auf die Patenterteilung: **27.09.1995**
(21) Anmeldenummer: 90122579.7
(22) Anmeldetag: 27.11.1990
(51) Int. Cl.: H05K 9/00

(54) **Berührungsdichtung**
Contact seal
Joint de contact

(30) Priorität: 21.03.1990 DE 4009079
(43) Veröffentlichungstag der Anmeldung: 25.09.1991
(73) Patentinhaber: Eurocopter Deutschland Gesellschaft mit beschränkter Haftung, D-81611 München (DE)
(72) Erfinder: Eschenfelder, Peter, W-8269 Waldkraiburg (DE); Scheitle, Johann Peter, W-8000 München 83 (DE)
(74) Vertreter: Frick, Gerhard, Dipl.-Ing.

(56) Entgegenhaltungen:
- EP-A- 0 379 159
- DE-A- 1 982 467
- DE-A- 2 829 255
- DE-B- 1 191 870
- US-A- 3 502 784

## Beschreibung

Die Erfindung betrifft eine Berührungsdichtung gemäß dem Oberbegriff des Patentanspruchs 1.

Eine Berührungsdichtung gemäß dem Oberbegriff des Anspruchs 1 ist aus dem Dokument DE-A-1 982 467 bekannt.

Bei Dichtungsmaterial zum fluiddichten Abdichten und zugleich elektromagnetischen Abschirmen oder elektrischen Überbrücken von Trennfugen ist üblicherweise der Kern ein Metalldrahtgeflecht. Neben seiner elektrischen Leiterfunktion hat ein solches Metalldrahtgeflecht unerwünschtermaßen eine Versteifung des Dichtungsmaterials zur Folge, so daß es unebenen Fugenflächen nur schwer anpaßbar ist. Daher ist auch schon vorgeschlagen worden, das Dichtungsmaterial vom elektrisch leitenden Dichtungsteil zu trennen bzw. zu befreien und nur noch am Abdichtprofil eine aus Metallitzen gebildete Abschirmkordel anzubringen (DE-OS 28 29 255). Erfahrungsgemäß ist jedoch bei dieser Dichtung auf Dauer eine beträchtliche Minderung der Leitfähigkeit durch Verunreinigung und Beschädigung der Abschirmkordel nicht zu verhindern, zumal dafür in der Trennfuge keinerlei Feuchtigkeits- bzw. Korrosionsschutz durch den Dichtwerkstoff besteht.

Der Erfindung liegt daher die Aufgabe zugrunde, bei einer Berührungsdichtung der eingangs genannten Art eine dauerhaft wirksame elektrische Anbindung des stationären an das bewegbare Bauteil mit einem leitenden Dichtungsteil sicherzustellen, welche in der Trennfuge durch den flexiblen Dichtungsteil schützbar ist.

Diese Aufgabe ist für eine gattungsgemäße Berührungsdichtung mit den kennzeichnenden Merkmalen des Patentanspruchs 1 gelöst. Eine derartige Berührungsdichtung läßt sich aufgrund der Leistenform des elektrisch leitenden Dichtungsteils in großflächigem Kontakt mit dem stationären Bauteil mittels einfacher Verbindungsteile form- und kraftschlüssig vereinigen, wobei die Positionierung des elektrisch leitenden und flexiblen Dichtungsteils nacheinander, d.h. gesondert möglich ist, so daß nicht nur die Berührungsdichtung dem räumlichen Verlauf der Trennfuge entsprechend leicht ausrichtbar, sondern auch der elektrisch leitende Dichtungsteil durch den flexiblen Dichtungsteil sorgfältig abdeckbar ist. Die elektrischen Verbindungsstege "Laschen" zu den das bewegbare Bauteil kontaktenden Federmitteln sind dabei zugleich zur Fixierung des flexiblen Dichtungsteils nutzbar. Schließlich läßt sich durch die Federmittel, vorzugsweise in der im Anspruch 2 gekennzeichneten Ausgestaltung, die Anzahl der durch die Stege verfügbaren Kontaktstellen für das bewegbare Bauteil erheblich vervielfachen. Da sämtliche Dichtungsteile lösbar verbunden werden können, ist erforderlichenfalls auch der teilweise Ersatz problemlos möglich.

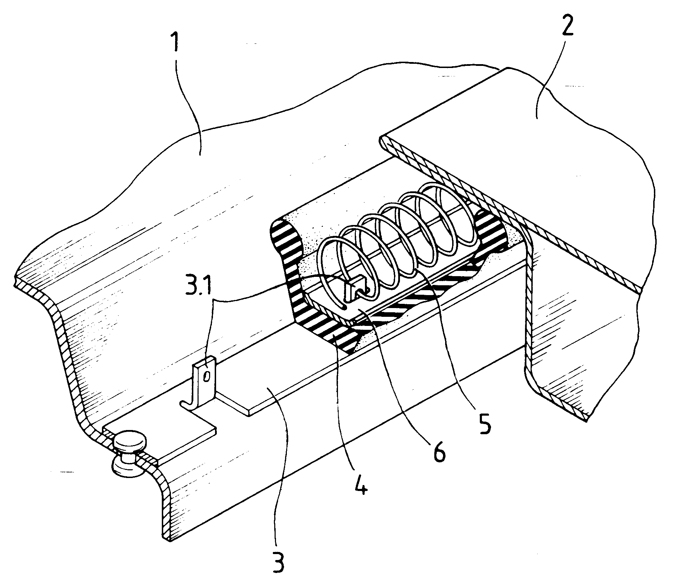

Nachfolgend wird die Erfindung anhand eines Ausführungsbeispiels weiter erläutert. Dabei zeigt die Zeichnung in einer Perspektive einen Ausschnitt einer Trennfuge zwischen einem stationären Bauteil 1 , z.B. einem Rahmen, und einem demgegenüber bewegbaren Bauteil 2, z.B. einem Türflügel. In der dargestellten geschlossenen Position des bewegbaren Bauteils 2 soll die Verbindungsfuge fluiddicht sein und zugleich elektrisch leitend überbrückt werden, so daß die beiden Bauteile 1 , 2 in entsprechendem Kontakt miteinander stehen. Zu diesem Zweck ist in der Verbindungsfuge eine (aufgebrochen dargestellte) Berührungsdichtung eingefügt, bei welcher am stationären Bauteil 1 z.B. mittels Niete eine Leiste 3 aus Metall befestigt ist. Diese als elektrisch leitender Dichtungsteil fungierende Leiste 3 ist die Basis eines fluiddichten, flexiblen Dichtungsteils 4 z.B. aus Gummi, welcher sich unter vollständiger Bedeckung der Leiste 3 entlang erstreckt und dabei von Laschen 3.1 derselben durchdrungen wird. Zum einen fixieren die Laschen 3.1 den flexiblen Dichtungsteil 4, zum anderen dienen sie der elekrischen Verbindung der Leiste 3 bzw. des stationären Bauteils 1 mit dem bewegbaren Bauteil 2, wobei der Kontakt sämtlicher Laschen 3.1 mit diesem Bauteil 2 über eine hiergegen drückende elektrisch leitende Schraubenfeder 5 hergestellt ist. Die Schraubenfeder 5 erstreckt sich längs des flexiblen Dichtungsteils 4 gestützt auf einer zwischengefügten relativ harten Auflage 6, so daß der Druckkontakt der Schraubenfeder 5 bzw. ihrer Windungen mit dem bewegbaren Bauteil 2, je nach Abmessung und Material des flexiblen Dichtungsteils 4, ohne Gefahr einer schädigenden Beanspruchung dieses Dichtungsteils 4 sichergestellt ist.

Die Schraubenfeder 5 wird mit den dargestellten Laschen 3.1 durch Eindrehen in deren Ausnehmungen in Eingriff gebracht; je nach Gestaltung der Laschen ist auch ein Einhaken denkbar.

## Patentansprüche

1. Berührungsdichtung für eine Trenn- oder Verbindungsfuge zwischen einem stationären und einem demgegenüber bewegbaren Bauteil (1 bzw. 2), insbesondere Türdichtung, mit einem fluiddichten, flexiblen Dichtungsteil (4) im Verbund mit einem dagegen relativ harten, elektrisch leitenden Dichtungsteil (3), **dadurch gekennzeichnet**, daß der elektrisch leitende Dichtungsteil eine am stationären Bauteil (1) befestigtbare Leiste (3) mit den hierauf sich erstreckenden flexiblen Dichtungsteil (4) durchdringenden Laschen (3.1) ist, welche mit elektrisch leitenden Federmitteln (5) zum Drücken gegen den bewegbaren Bauteil (2) in Kontakt stehen.

2. Berührungsdichtung nach Anspruch 1, **gekennzeichnet** durch Federmittel in Form einer dem flexiblen Dichtungsteil (4) entlang sich erstreckenden Schraubenfeder (5), welche bzw. deren Windungen sich im Eingriff mit den Laschen (3.1) über eine relativ harte Auflage (6) auf dem flexiblen Dichtungsteil (4) abstützen.

## Claims

1. Contact seal for a separation or connection joint between a stationary component and a component which is movable relative to the latter (1 or 2), in particular a door seal, having a fluid-tight, flexible seal part (4) in conjunction with an, in contrast, relatively hard, electrically conducting seal part (3), characterized in that the electrically conducting seal part is a strip (3) which can be attached to the stationary component (1) and has tabs (3.1) which pass through the flexible seal part (4) extending on said strip and are in contact with electrically conducting spring means (5) for pressing against the movable component (2).

2. Contact seal according to Claim 1, characterized by spring means in the form of a helical spring (5) extending along the flexible seal part (4), which spring means or their turns are supported on the flexible seal part (4) via a relatively hard rest (6) in engagement with the tabs (3.1).

## Revendications

1. Joint d'étanchéité à contact pour un interstice de séparation ou de jonction entre un élément fixe et un élément mobile par rapport au premier (éléments 1 et 2), notamment joint de porte, comportant une partie (4) de joint souple, étanche aux fluides, combinée à une partie (3) de joint relativement dure, conductrice de l'électricité, caractérisé par le fait que la partie de joint conductrice de l'électricité est une barrette (3) fixée sur l'élément fixe (1) pourvue de pattes (3.1) qui traversent la partie de joint (4) souple placée sur elle, lesquelles pattes sont en contact avec des moyens élastiques (5) conducteurs de l'électricité qui sont pressés contre l'élément (2) mobile.

2. Joint d'étanchéité à contact selon la revendication 1, caractérisé par des moyens élastiques en forme de ressort (5) hélicoïdal qui s'étend le long de la partie de joint (4) souple, ressort qui est ou dont les les spires sont en prise avec les pattes (3.1) et prennent appui par l'intermédiaire d'une semelle (6) relativement dure sur la partie (4) souple du joint.
